(19) Europäisches Patentamt

European Patent Office

Office européen des brevets

(11) Veröffentlichungsnummer: **0 216 137 B1**

(12) # EUROPÄISCHE PATENTSCHRIFT

(45) Veröffentlichungstag der Patentschrift: **23.09.92**

(51) Int. Cl.⁵: **H03M 1/00**, H03M 1/16

(21) Anmeldenummer: **86111451.0**

(22) Anmeldetag: **16.08.86**

(54) **Verfahren zur Reduktion der Datenmenge bei der Umwandlung eines analogen elektrischen Signals in ein digitales Signal sowie Einrichtung zur Durchführung des Verfahrens.**

(30) Priorität: **21.09.85 DE 3533708**

(43) Veröffentlichungstag der Anmeldung:
**01.04.87 Patentblatt 87/14**

(45) Bekanntmachung des Hinweises auf die
Patenterteilung:
**23.09.92 Patentblatt 92/39**

(84) Benannte Vertragsstaaten:
**AT BE CH DE GB IT LI LU NL SE**

(56) Entgegenhaltungen:
**FR-A- 2 515 725**
**GB-A- 1 301 292**
**GB-A- 2 076 241**
**US-A- 4 161 782**

(73) Patentinhaber: **Neumann Elektronik GmbH**
**Bülowstrasse 104 - 110**
**W-4330 Mülheim 1(DE)**

(72) Erfinder: **Neumann, Dirk, Dipl.-Ing.**
**Schemelsbruch 11**
**W-4330 Mülheim 1(DE)**

(74) Vertreter: **Feder, Heinz, Dr. et al**
**Dominikanerstrasse 37 Postfach 11 04 26**
**W-4000 Düsseldorf 11(DE)**

EP 0 216 137 B1

## Beschreibung

Die Erfindung betrifft ein Verfahren und eine Einrichtung zur Reduktion der Datenmenge bei der Umwandlung eines analogen elektrischen Signals in ein digitales Signal durch Abtastung des analogen Signals mit in Abhängigkeit vom Eingangssignal variierender Abtastfrequenz.

Ein solches Verfahren ist beispielsweise in der DE-OS 31 17 920 beschrieben.

Derartige Verfahren werden beispielsweise angewendet zur Aufnahme und Speicherung von Sprachtexten bei elektronischen Textgebern in Telefon-Anrufbeantwortern.

Die Abtastung des analogen Signals kann dabei in verschiedener Weise nach bekannten Verfahren, beispielsweise dem Puls-Code-Modulations-Verfahren oder auch dem Delta-Modulations-Verfahren, erfolgen.

Die Abtastfrequenz und damit die Anzahl der digitalen Signalwerte legen den Bedarf an Speicherplätzen fest, wenn das digitale Signal beispielsweise in einem Festkörperspeicher gespeichert werden soll. Je höher die Abtastfrequenz ist um so mehr Speicherplätze werden benötigt. Es ist bekannt, daß der Störabstand eines digitalen Signals, also das Signal/Rausch-Verhältnis, um so besser ist, je höher die Abtastfrequenz gewählt wird. Dies hat zur Folge, daß zur Erzielung eines besseren Störabstandes auch eine größere Datenmenge und damit ein größerer Bedarf an Speicherplätzen auftritt.

Bei dem obenerwähnten bekannten Verfahren soll eine Reduktion der Datenmenge dadurch erreicht werden, daß bei einer langsamen Änderung der Amplitude des Eingangssignals mit niedriger Frequenz abgetastet wird, während bei einer schnellen Änderung der Amplitude des Eingangssignals mit höherer Abtastfrequenz abgetastet wird. So wird beispielswiese bei dem bekannten Verfahren bei kleiner Eingangsamplitude und niedriger Eingangsfrequenz mit einer niedrigen Abtastfrequenz gearbeitet, was den Nachteil hat, daß Störfrequenzen mit etwa gleichem Pegel wie die Nutzfrequenz auftreten können.

Außerdem müssen bei dem bekannten Verfahren Informationen über die jeweilige Abtastfrequenz mit gespeichert werden, um eine einwandfreie Rückübertragung in ein analoges Signal sicherzustellen.

Die der Erfindung zugrunde liegende Aufgabe bestand darin, ein Verfahren der eingangs und im Oberbegriff des Patentanspruches 1 genannten Art zu schaffen, bei dem trotz ausreichenden Störabstandes die Menge der anfallenden Daten möglichst niedrig gehalten werden kann.

Die Erfindung geht von der Erkenntnis aus, daß bei einem analogen elektrischen Signal mit hohem Eingangspegel eine niedrigere Abtastfrequenz erforderlich ist, um einen ausreichenden Störabstand zu erhalten als bei einem analogen Signal mit niedrigem Eingangspegel. Die Lösung der obengenannten Aufgabe erfolgt demgemäß mit den Merkmalen aus dem kennzeichnenden Teil des Patentanspruches 1. Vorteilhafte Ausführungsformen des erfindungsgemäßen Verfahrens sind in den Ansprüchen 2 bis 5 beschrieben. Die angestrebte Reduktion der Datenmenge wird dadurch erreicht, daß nicht mit einer festen Abtastfrequenz, sondern mit einer variablen Abtastfrequenz gearbeitet wird. Diese Abtastfrequenz wird dem jeweiligen Eingangspegel des analogen Signals angepaßt, und zwar so, daß bei hohem Eingangspegel mit einer relativ niedrigen Abtastfrequenz und bei niedrigem Eingangspegel mit einer relativ hohen Abtastfrequenz gearbeitet wird. Dies hat zur Folge, daß die Gesamtmenge an zu speichernden digitalen Daten erheblich niedriger ist als wenn man die Abtastung des analogen Signals ständig mit möglichst hoher Abtastfrequenz durchführte, andererseits ist aber auch bei analogen Signalen mit niedrigem Eingangspegel ein noch ausreichender Störabstand sichergestellt, indem in diesen Fällen die Abtastfrequenz auf einen höheren Wert gesteuert wird.

Da die Variation der Abtastfrequenz vom absoluten Wert des Eingangspegels abhängt, ist es bei dem erfindungsgemäßen Verfahren nicht notwendig, besondere Informationen über die jeweilige Abtastfrequenz zu speichern. Es ist vielmehr ausreichend, wenn bei der Rückumwandlung gemäß den Merkmalen nach Patentanspruch 5 vorgegangen wird.

Die Variation der Abtastfrequenz kann entweder in einzelnen Stufen zwischen einem vorgegebenen Maximalwert und einem vorgegebenen Minimalwert erfolgen, sie kann aber auch stufenlos erfolgen.

Gegenstand der Erfindung sind weiterhin Einrichtungen zur Durchführung des erfindungsgemäßen Verfahrens, deren Merkmale in den Patentansprüchen 6 und 7 beschrieben sind.

Im folgenden wird anhand der beigefügten Zeichnungen ein Ausführungsbeispiel für das erfindungsgemäße Verfahren und eine Einrichtung zu dessen Durchführung näher erläutert.

In den Zeichnungen zeigen:

Fig. 1    in einem Prinzipschaltbild eine Einrichtung zur Umwandlung eines analogen elektrischen Signals in ein digitales Signal sowie Zurückumwandlung des digitalen Signals in ein analoges Signal;

Fig. 2    in einer graphischen Darstellung den Zusammenhang zwischen dem Störabstand und dem Eingangspegel des analogen Signals bei verschiedenen Abtastfrequenzen.

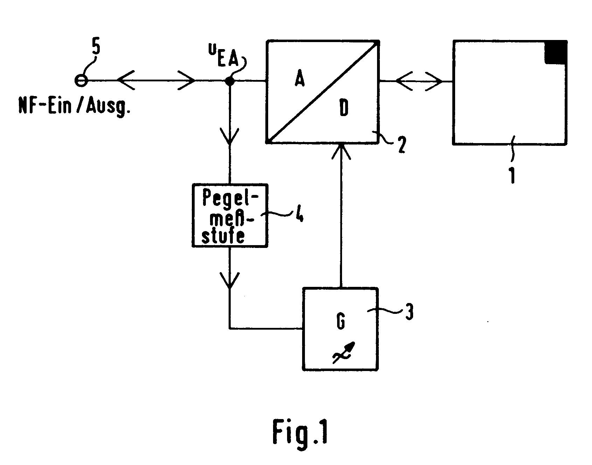

Die in Fig. 1 dargestellte Schaltung zeigt einen beispielsweise als programmierbarer Festkörperspeicher ausgebildeten Speicher 1, dem ein Analog/Digital-Digital/Analog-Wandler 2 vorgeschaltet ist, dessen Taktfrequenz durch einen Taktgenerator 3 mit ansteuerbarer variabler Taktfrequenz bestimmt wird.

Der Analog-Ein/Ausgang des Analog/Digital-Digital/Analog-Wandlers 2 ist an eine Pegelmeßstufe 4 angeschlossen, durch die die Ein/Ausgangsspannung UEA des am Eingang 5 der Einrichtung zu- bzw. abgeführten NF-Ein/Ausgangssignals gemessen und ein dieser Spannung UEA proportionales Steuersignal erzeugt wird, mit der der Taktgenerator 3 angesteuert wird, und zwar so, daß sich seine Ausgangsfrequenz im wesentlichen umgekehrt proportional zur Höhe des Steuersignals ändert.

Dies hat zur Folge, daß bei hohem Eingangspegel bzw. Ausgangspegel des analogen Signals mit niedriger Taktfrequenz gearbeitet wird, während bei niedrigem Eingangspegel bzw. Ausgangspegel mit hoher Taktfrequenz gearbeitet wird.

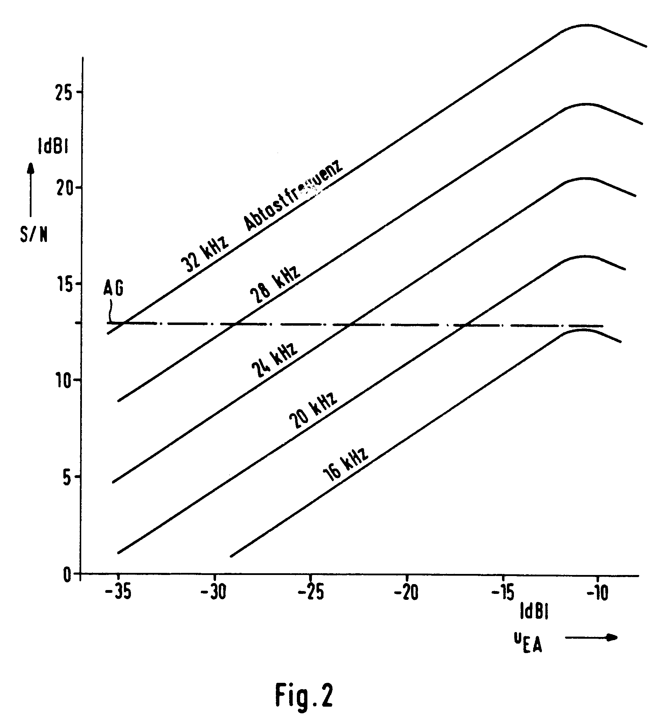

Die Zusammenhänge sind in Fig. 2 dargestellt. In Fig. 2 ist in einer graphischen Darstellung der Störabstand S/N (in dB) in Abhängigkeit von der Ein/Ausgangsspannung UEA (in dB) dargestellt, und zwar jeweils bei verschiedenen Abtastfrequenzen im Bereich zwischen 16 kHz und 32 kHz. Um einen ausreichenden Störabstand von S/N = 13dB aufrechtzuerhalten, wird die Abtastfrequenz in Abhängigkeit von der Spannung UEA so variiert, daß sie sich auf der in Fig. 2 strichpunktiert eingezeichneten Arbeitsgeraden AG bewegt. Dadurch ist gewährleistet, daß stets der gleiche insgesamt ausreichende Störabstand eingehalten wird bei hohen Signalpegeln aber durch die entsprechende Verringerung der Abtastfrequenz eine erhebliche Reduktion der Datenmenge erzielt wird.

Bei der Durchführung des Verfahrens bzw. der Auslegung der entsprechenden Einrichtungen ist es von Wichtigkeit, daß bei der Rückumwandlung des digitalen Signals in ein analoges Signal die Ansteuerung des Analog/Digital-Digital/Analog-Wandlers 3 mit einer Taktfrequenz erfolgt, die für jeden einzelnen Signalwert genau der Abtastfrequenz entspricht, die bei der Umwandlung des analogen Signals in das digitale Signal für den entsprechenden Wert verwendet wurde. Aus diesem Grunde ist es bei der Einrichtung zweckmäßig, einen in beiden Richtungen wirksamen Wandler zu verwenden, oder wenn unterschiedliche Wandler verwendet werden, müssen sie in ihren Kenngrößen genau übereinstimmen, damit eine exakte Rückumwandlung des Signals erfolgt.

Es wird noch darauf hingewiesen, daß das beschriebene Verfahren von der speziellen Ausbildung des Abtastverfahrens unabhängig ist und beispielsweise sowohl bei einem PCM-Verfahren als auch bei einem Verfahren mit Delta-Modulation anwendbar ist.

**Patentansprüche**

1. Verfahren zur Reduktion der Datenmenge bei der Umwandlung eines analogen elektrischen Signals in ein digitales Signal durch Abtastung des analogen Signals mit in Abhängigkeit vom Eingangssignal variierender Abtastfrequenz, dadurch gekennzeichnet, daß der Eingangspegel des analogen Signals fortlaufend gemessen wird und die Abtastfrequenz in Abhängigkeit vom gemessenen Eingangspegel fortlaufend derart variiert wird, daß einem hohen Eingangspegel eine niedrige Abtastfrequenz und einem niedrigen Eingangspegel eine höhere Abtastfrequenz zugeordnet wird.

2. Verfahren nach Anspruch 1, dadurch gekennzeichnet, daß die Variation der Abtastfrequenz in Stufen zwischen einem vorgegebenen Maximalwert und einem vorgegebenen Minimalwert erfolgt.

3. Verfahren nach Anspruch 1, dadurch gekennzeichnet, daß die Variation der Abtastfrequenz stufenlos zwischen einem vorgegebenen Maximalwert und einem vorgegebenen Minimalwert erfolgt.

4. Verfahren nach einem der Ansprüche 1 bis 3, dadurch gekennzeichnet, daß die Variation der Abtastfrequenz mindestens innerhalb vorgegebener Teilbereiche der gemessenen Eingangspegelwerte im wesentlichen umgekehrt proportional zum Eingangspegel verläuft.

5. Verfahren nach einem der Ansprüche 1 bis 4, bei dem die Einzelwerte des digitalen Signals gespeichert und anschließend das digitale Signal wieder in ein analoges Signal umgewandelt wird, dadurch gekennzeichnet, daß bei der Umwandlung des digitalen in ein analoges Signal der Ausgangspegel des analogen Signals fortlaufend gemessen und die Auslesefrequenz in Abhängigkeit vom gemessenen Ausgangspegel fortlaufend derart variiert wird, daß jedem Signalwert die Auslesefrequenz zugeordnet wird, die der diesem Signalwert zugeordneten Abtastfrequenz bei der vorangegangenen Umwandlung des analogen Signals in ein digitales Signal entspricht.

6. Einrichtung zur Reduktion der Datenmenge bei der Umwandlung eines analogen elektrischen Signals in ein digitales Signal durch Abtastung des analogen Signals mit in Abhängigkeit vom Eingangssignal variierender Abtastfrequenz, gekennzeichnet durch einen Analog/Digital-Wandler (2), an dessen Eingang eine Pegelmeßstufe (4) angeschlossen ist, die ein den gemessenen Eingangspegel des analogen Signals proportionales Steuersignal erzeugt, das dem die Tahtfrequenz abhängig von der Pegelhöhe steuernden Steuereingang eines den Analog/Digital-Wandler ansteuernden Taktgenerators (3) mit steuerbarer Taktfrequenz zugeführt wird.

7. Einrichtung zur Reduktion der Datenmenge bei der Umwandlung eines analogen elektrischen Signals in ein digitales Signal durch Abtastung des analogen Signals mit in Abhängigkeit vom Eingangssignal variierender Abtastfrequenz wobei die Einzelwerte des digitalen Signals gespeichert und anschließend das digitale Signal wieder in ein analoges Signal umgewandelt wird, gekennzeichnet durch einen Speicher (1), dem ein Analog/Digital-Digital/Analog-Wandler (2) vorgeschaltet ist, an dessen Analog-Ein/Ausgang eine Pegelmeßstufe (4) angeschlossen ist, die ein den gemessenen Eingangs- bzw. Ausgangspegel des analogen Signals proportionales Steuersignal erzeugt, das dem die Tahtfrequenz abhängig von der Pegelhöhe steuernden Steuereingang eines dem Analog/Digital-Digital/Analog-Wandler ansteuernden Taktgenerators (3) mit steuerbarer Taktfrequenz zugeführt wird.

**Claims**

1. Method for the reduction of the quantity of data during the conversion of an analog electrical signal into a digital signal by sampling the analog signal with a sampling frequency which varies as a function of the input signal, characterised in that the input level of the analog signal is continuously measured and the sampling frequency is continuously varied as a function of the measured input level in such a way that a low sampling frequency is associated with a high input level and a relatively high sampling frequency is associated with a low input level.

2. Method according to Claim 1, characterised in that the variation of the sampling frequency takes place in stages between a predetermined maximum value and a predetermined minimum value.

3. Method according to Claim 1, characterised in that the variation of the sampling frequency takes place in an infinitely variable manner between a predetermined maximum value and a predetermined minimum value.

4. Method according to one of Claims 1 to 3, characterised in that variation in the sampling frequency progresses essentially in inverse proportion to the input level at least within predetermined sub-areas of the measured input level values.

5. Method according to one of Claims 1 to 4, in which the individual values of the digital signal are stored and subsequently the digital signal is converted back into an analog signal, characterised in that in the case of the conversion of the digital signal into an analog signal the output level of the analog signal is continuously measured and the read-out frequency is continuously varied as a function of the measured output level in such a way that each signal value has the read-out frequency assigned to it which corresponds to the sampling frequency which is associated with this signal value during the preceding conversion of the analog signal into a digital signal.

6. Device for the reduction of the quantity of data during the conversion of an analog electrical signal into a digital signal by sampling the analog signal with a sampling frequency which varies as a function of the input signal, characterised by an analog-to-digital converter (2), to the input of which a level measuring stage (4) is connected which generates a control signal which is proportional to the measured input level of the analog signal and is fed to the control input, which controls the clock frequency as a function of the level, of a clock generator (3), which drives the analog-to-digital converter, with controllable clock frequency.

7. Device for the reduction of the quantity of data during the conversion of an analog electrical signal into a digital signal by sampling the analog signal with a sampling frequency which varies as a function of the input signal, in which case the individual values of the digital signal are stored and subsequently the digital signal is converted back into an analog signal, characterised by a memory (1), upstream of which an analog-to-digital/digital-to-analog converter (2) is connected, to whose analog input/output a level measuring stage (4) is connected which generates a control signal which is proportional to the measured input level or output level of the digital signal and which is fed to the control input, which controls the clock frequency as a function of the level, of a clock generator (3) which drives the analog-to-digital/digital-to-analog converter, with controllable clock frequency.

**Revendications**

1. Méthode pour réduire la quantité de données pendant la conversion d'un signal électrique analogique en signal numérique à analyse du signal analogique avec une fréquence d'analyse variant en fonction du signal d'entrée, caractérisée en ce que le niveau d'entrée du signal analogique est continuellement mesuré et que la fréquence d'analyse est continuellement modifiée en fonction du niveau d'entrée mesuré et en ce qu'un niveau d'entrée élevé correspond à une fréquence d'analyse faible et qu'un niveau d'entrée faible correspond à une fréquence d'analyse plus élevée.

2. Méthode selon la revendication 1, caractérisée en ce que la variation de la fréquence d'analyse est effectuée par étapes entre une valeur maximale prédéterminée et une valeur minimale prédéterminée.

3. Méthode selon la revendication 1, caractérisée en ce que la variation de la fréquence d'analyse a lieu de manière continue entre une valeur maximale prédéterminée et une valeur minimale prédéterminée.

4. Méthode selon l'une des revendications 1 à 3, caractérisée en ce que la variation de la fréquence d'analyse se produit de manière essentiellement inversement proportionnelle au niveau d'entrée, au moins dans des domaines partiels prédéterminés des valeurs de niveaux d'entrée mesurés.

5. Méthode selon l'une des revendications 1 à 4, dans laquelle les différentes valeurs du signal numérique sont mises en mémoire et le signal numérique est ensuite converti à nouveau en signal analogique, caractérisée en ce que, au cours de la conversion du signal numérique en signal analogique, le niveau de sortie du signal analogique est mesuré en continu et que la fréquence de lecture est continuellement modifiée en fonction du niveau de sortie mesuré de façon que, à chaque valeur de signal, corresponde la fréquence de lecture qui correspond à la fréquence d'analyse correspondant à cette valeur de signal au cours de la conversion précédente du signal analogique en signal numérique.

6. Dispositif pour réduire la quantité de données pendant la conversion d'un signal électrique analogique en signal numérique par analyse du signal analogique avec une fréquence d'analyse variant en fonction du signal d'entrée, caractérisé par un convertisseur analogique/numérique (2) à l'entrée duquel est raccordé un étage de mesure de niveau (4) qui produit un signal de commande proportionnel au niveau d'entrée mesuré du signal analogique, ledit signal étant amené à l'entrée de commande réglant la fréquence d'impulsions en fonction du niveau d'un générateur d'impulsions (3) commandant le convertisseur analogique/numérique avec la fréquence d'impulsions réglable.

7. Dispositif pour réduire la quantité de données pendant la conversion d'un signal électrique analogique en signal numérique par analyse du signal analogique avec une fréquence d'analyse variant en fonction du signal d'entrée, dans lequel les différentes valeurs du signal numérique dont mises en mémoire tandis que le signal numérique est ensuite converti à nouveau en signal analogique, caractérisé par une mémoire (1) précédée par un convertisseur analogique/numérique - numérique/analogique (2) à l'entrée/sortie analogique duquel est raccordé un étage de mesure de niveau (4) qui produit un signal de commande proportionnel au niveau d'entrée/sortie mesuré du signal analogique qui est amené à l'entrée de réglage commandant la fréquence d'impulsions en fonction du niveau d'un générateur d'impulsions (3) commandant le convertisseur analogique/numérique - numérique/analogique avec fréquence d'impulsions réglable.

Fig.1

Fig.2